# EUROPEAN PATENT APPLICATION

(11) **EP 4 831 971 A1**
(43) Date of publication of application: **28.10.2026**
(21) Application number: 26171585.8
(22) Date of filing: 10.04.2026
(51) Int. Cl.: G09F 9/33, G09F 9/30

(54) **LED FLEXIBLE MEMBRANE SCREEN**

(30) Priority: 25.04.2025 CN 202520802529 U
(71) Applicant: Shangyou Jiayi Lighting Product Co., Ltd., Huangbu Town, Shangyou County Ganzhou City Jiangxi 314000 (CN)
(72) Inventor: HE, Yaowen, Ganzhou, 341000 (CN)
(74) Representative: Huang, Liwei

(57) **Abstract**

An LED flexible membrane screen includes a first flexible membrane and a second flexible membrane and a flexible interlayer sandwiched between the first flexible membrane and the second flexible membrane, a plurality of (multiple) LED partitions are arranged in the flexible interlayer, and each LED partition includes a plurality of (multiple) LED display units, each LED display unit includes an LED luminous body and a flexible circuit connected with the LED luminous body, and the thickest wire in the flexible circuit has a second size, the second size being much smaller than the first size. The LED flexible membrane screen disclosed in the present disclosure has a flexible portion that can be bent, folded, and curled, enabling installation on complex surfaces such as cylindrical structures, curved walls, and irregular architectures. This design overcomes the limitations of traditional rigid screens while achieving a total thickness of approximately 4 mm for the flexible portion, a light transmittance of at least 80%, and support for individual control and partitioned control of LED display.

## Description

### TECHNICAL FIELD

The present disclosure relates to the field of LED display, and in particular, to an LED flexible membrane screen.

### BACKGROUND OF THE INVENTION

In scenarios such as shopping mall windows, exhibition displays, and architectural glass curtain walls, traditional rigid screens are difficult to fit seamlessly very well. Furthermore, modern architectural designs increasingly adopt curved, arcuate, or irregular geometric forms (e.g., wave-patterned glass curtain walls, arc-shaped windows). Typically, traditional rigid screens cannot be installed on curved walls, cylindrical structures, or irregularly shaped frameworks.

In view of this, it is necessary to develop a new LED flexible membrane screen to overcome the technical problem of the prior art.

### SUMMARY OF THE INVENTION

In order to solve the above technical problem, the present disclosure provides an LED flexible membrane screen, wherein,
the LED flexible membrane screen includes a first flexible membrane and a second flexible membrane, and,
a flexible interlayer sandwiched between the first flexible membrane and the second flexible membrane,
wherein,
the first flexible membrane, the second flexible membrane and the flexible interlayer form a multi-layer structure as a flexible portion of the LED flexible membrane screen,
the shapes of the first flexible membrane, the second flexible membrane, and the flexible interlayer are all the same, which is a first shape,
edges of the first flexible membrane, the second flexible membrane, and the flexible interlayer are flush, and all have the same size, which is a first size;
a plurality of (multiple) LED partitions are arranged in the flexible interlayer, and
each LED partition includes a plurality of (multiple) LED display units, each LED display unit includes an LED luminous body and a flexible circuit connected with the LED luminous body, and the thickest wire in the flexible circuit has a second size, the second size being much smaller than the first size.

Preferably,
when the first flexible membrane, the second flexible membrane, and the flexible interlayer are all rectangular, the first size includes the length and width of the flexible membrane; and
when the first flexible membrane, the second flexible membrane, and the flexible interlayer are all square, the first size includes the edge length of the flexible membrane.

Preferably,
the second size is the outer diameter of the thickest wire in the flexible circuit.

Preferably,
the flexible circuit is free of a PCB.

Preferably,
the flexible interlayer includes a first flexible layer and a second flexible layer,
the first flexible layer is adjacent to the first flexible membrane,
the second flexible layer is adjacent to the second flexible membrane, and
the plurality of (multiple) LED partitions and LED display units are arranged between the first flexible layer and the second flexible layer, such that the LED partitions and the LED display units are sandwiched by doubled layers consisting of the first flexible membrane, the first flexible layer, the second flexible layer and the second flexible membrane.

Preferably,
the second size is set with reference to the resolution and/or pixel density of the LED flexible membrane screen.

Preferably,
the spacing of adjacent LED beads is set with reference to the resolution and/or pixel density of the LED flexible membrane screen.

Preferably,
the flexible interlayer is a thermally conductive flexible interlayer.

Preferably,
the first flexible membrane and the second flexible membrane each have thermal conductivity.

Preferably,
the flexible portion is free of a PCB.

Preferably,
the flexible portion is able to be bent, folded, and curled.

Preferably,
the flexible portion is able to be cropped.

Preferably,
the LED flexible membrane is capable of bi-directional display on the respective outer sides of the first flexible membrane and the second flexible membrane via the LED beads.

Preferably,
one side of the multi-layer structure formed by the first flexible membrane, the second flexible membrane and the flexible interlayer is provided with a rigid portion of the LED flexible membrane screen, the rigid portion including a hollow housing.

Preferably,
the flexible portion of the LED flexible membrane is able to be curled to wrap the rigid portion when the LED flexible membrane is not deployed.

Preferably,
the light transmittance of the LED flexible membrane screen is greater than or equal to 80%.

Preferably,
the LED flexible membrane screen is a pixel controllable LED flexible membrane screen, and the thickness of the LED flexible membrane screen is 3-5 mm.

Preferably,
the materials of the first flexible membrane, the second flexible membrane, and the flexible interlayer include, but are not limited to, silicone, PVC, PET, or polyurethane polymer flexible materials.

Preferably,
the LED flexible membrane screen includes a plurality of (multiple) LED luminous bodies in an array, wherein at least a part of the plurality of (multiple) LED luminous bodies in the array form a first LED display unit and a first LED partition thereof, and another part of the plurality of (multiple) LED luminous bodies in the array form a second LED display unit and a second LED partition thereof.

Preferably,
the rigid portion is used to fix a power supply module and other circuit modules other than the power supply module.

Preferably,
the size of the rigid portion in one dimension is smaller than or equal to one edge of the corresponding flexible portion, and,
the maximum size of the rigid portion in other dimensions is much smaller than another edge of the flexible portion, so that the LED flexible membrane is able to wrap the rigid portion by curling the flexible portion.

Preferably,
each LED bead is controlled by an independent signal to achieve a pixel-level dynamic effect.

Preferably,
the LED bead is a 360-degree circumferential (omni-directional) light-emitting bead.

Preferably,
the flexible portion is able to be cropped, and the cropping does not affect the display function of the remaining flexible portion as the flexible membrane screen.

In summary, the present disclosure has the following features:
the LED flexible membrane screen disclosed in the present disclosure has a flexible portion that can be bent, folded, and curled, enabling installation on complex surfaces such as cylindrical structures, curved walls, and irregular architectures. This design overcomes the limitations of traditional rigid screens while achieving a total thickness of approximately 4 mm for the flexible portion, a light transmittance of at least 80%, and support for individual control and partitioned control of LED display.

### BRIEF DESCRIPTION OF DRAWINGS

In order to illustrate the technical solutions of the embodiments of the present disclosure more clearly, the drawings required for use in the embodiments will be briefly described below, it should be understood that the following drawings illustrate only certain embodiments of the present disclosure and are therefore not to be considered as limiting its scope, for those of ordinary skill in the art, further related drawings can be obtained from these drawings without the inventive step.
FIG. 1 is a schematic diagram of an LED flexible membrane screen in an incompletely flattened state according to an embodiment of the present disclosure;
FIG. 2 is a schematic diagram of an LED flexible membrane screen in a fully flattened state from one perspective; and
FIG. 3 is a schematic diagram of an LED flexible membrane screen in a fully flattened state from another perspective.

### DETAILED DESCRIPTION OF THE INVENTION

In order to make the objectives, technical solutions and advantages of the embodiments of the present disclosure more clear, the technical solutions in the embodiments of the present disclosure will be clearly and completely described below in conjunction with the accompanying drawings in the embodiments of the present disclosure, and it is obvious that the described embodiments are part of the embodiments of the present disclosure, rather than all of the embodiments. The components of the embodiments of the present disclosure as generally described and illustrated in the drawings herein could be arranged and designed in a wide variety of different configurations.

Thus, the following detailed description of the embodiments of the disclosure provided in the drawings is not intended to limit the scope of the disclosure, as claimed, but is merely representative of selected embodiments of the disclosure. Based on the embodiments in the present disclosure, all other embodiments obtained by those of ordinary skill in the art without making inventive labor, belong to the scope of protection of the present disclosure.

It should be noted that like reference numerals and letters represent like items in the following drawings, and therefore, once an item is defined in one drawing, it is not necessary to be further defined and explained in the following drawings.

In the description of the present disclosure, it should be noted that if the orientation or positional relationship indicated by the terms "upper", "lower", "inner", "outer", etc. is based on the orientation or positional relationship shown in the drawings, or is the orientation or positional relationship usually placed when the product of the present disclosure is used, it is only for convenience and simplification of the description of the present disclosure, and does not indicate or imply that the referred device or element must have a specific orientation, be constructed and operated in a specific orientation, and therefore cannot be understood as a limitation of the present disclosure.

Furthermore, the appearance of the terms "first", "second", etc. is merely used to distinguish the description, and should not be construed as indicating or implying relative importance.

It should be noted that the features in the embodiments of the present disclosure may be combined with each other without conflict.

In one embodiment, the present disclosure provides an LED flexible membrane screen, wherein,
the LED flexible membrane screen includes a first flexible membrane and a second flexible membrane, and,
a flexible interlayer sandwiched between the first flexible membrane and the second flexible membrane,
wherein,
the first flexible membrane, the second flexible membrane and the flexible interlayer form a multi-layer structure as a flexible portion of the LED flexible membrane screen,
the shapes of the first flexible membrane, the second flexible membrane, and the flexible interlayer are all the same, which is a first shape,
a size (e.g. the length and/or width) of the first flexible membrane, a size (e.g. the length and/or width) of the second flexible membrane, and a size (e.g. the length and/or width) of the flexible interlayer are the same, which is a first size,
an edge of the first flexible membrane, an edge of the second flexible membrane, and an edge of the flexible interlayer are flush;
a plurality of (multiple) LED partitions are arranged in the flexible interlayer, and
each LED partition includes a plurality of (multiple) LED display units, each LED display unit includes an LED luminous body and a flexible circuit connected with the LED luminous body, and the thickest wire in the flexible circuit has a second size (e.g. the diameter of the wire or the width/height of the wire), the second size being much smaller than the first size.

With respect to this embodiment, all of the LED partitions are disposed in the flexible interlayer and are not only protected by the flexible interlayer, but the heat of the LED partitions during operation (e.g., during image display) is also dispersed through the flexible interlayer, the first flexible membrane and the second flexible membrane to balance the flexibility and heat dissipation requirements through the first flexible membrane, the second flexible membrane and the flexible interlayer to avoid local overheating. At the same time, due to the presence of the first flexible membrane, the second flexible membrane and the flexible interlayer, the LED flexible membrane screen can be adapted to complex surface installation such as cylindrical structures, curved walls, irregular architectures and the like, thereby breaking through the limitations of the conventional rigid screens.

In some embodiments,
the flexible interlayer includes a first flexible layer and a second flexible layer,
the first flexible layer is adjacent to the first flexible membrane,
the second flexible layer is adjacent to the second flexible membrane, and
the plurality of (multiple) LED partitions and LED display units are arranged between the first flexible layer and the second flexible layer, such that the LED partitions and the LED display units are sandwiched by doubled layers formed by the first flexible membrane, the first flexible layer, the second flexible layer and the second flexible membrane.

With respect to the embodiment described above, when the flexible interlayer is viewed as a whole, the first flexible membrane, the second flexible membrane and the flexible interlayer actually form a sandwich structure. When the flexible interlayer includes a first flexible layer and a second flexible layer, the LED partitions and the LED display units located between the first flexible layer and the second flexible layer are located between the double interlayers formed by the first flexible membrane, the first flexible layer, the second flexible layer and the second flexible membrane. The structure of the double interlayers allows the product flexibility and product strength of the LED flexible membrane screen to be balanced.

In some embodiments,
the second size is set with reference to the resolution and/or pixel density of the LED flexible membrane screen.

In some embodiments,
the spacing of adjacent LED beads is set with reference to the resolution and/or pixel density of the LED flexible membrane screen.

It can be understood that the second size and the spacing of the adjacent LED beads arranged in the mode described above will meet the user's requirements for the image display, such as the resolution and/or pixel density of the LED flexible membrane screen. The spacing of the LED beads may further be set in conjunction with the distance from which the scene is viewed.

In some embodiments,
the flexible circuit is free of a PCB.

In some embodiments,
the flexible interlayer is a thermally conductive flexible interlayer.

Exemplarily, the flexible interlayer is a thermally conductive silicone interlayer.

In some embodiments,
the first flexible membrane and the second flexible membrane each have thermal conductivity.

In some embodiments,
the flexible portion is able to be bent, folded, and curled.

In some embodiments,
the flexible portion is able to be cropped.

In some embodiments,
the LED flexible membrane displays bi-directionally on the respective outer sides of the first flexible membrane and the second flexible membrane via the LED beads.

With respect to this embodiment, when both the first flexible membrane and the second flexible membrane are flexible membranes having a certain light transmittance and the LED beads are beads that emit light in a circumferential direction, the LED flexible membrane screen can display bi-directionally on the respective outer sides of the first flexible membrane and the second flexible membrane via the LED beads, thereby achieving a two-sided luminous effect.

In some embodiments,
one side of the multi-layer structure formed by the first flexible membrane, the second flexible membrane and the flexible interlayer is provided with a rigid portion of the LED flexible membrane screen, the rigid portion including a hollow housing.

In some embodiments,
the rigid portion is used to fix a power supply module and other circuit modules other than the power supply module.

It should be understood that the power supply module and other circuit modules are at least used to ensure that the LED flexible membrane screen can function normally.

In some embodiments,
the flexible portion of the LED flexible membrane is able to be curled to wrap the rigid portion when the LED flexible membrane is not deployed.

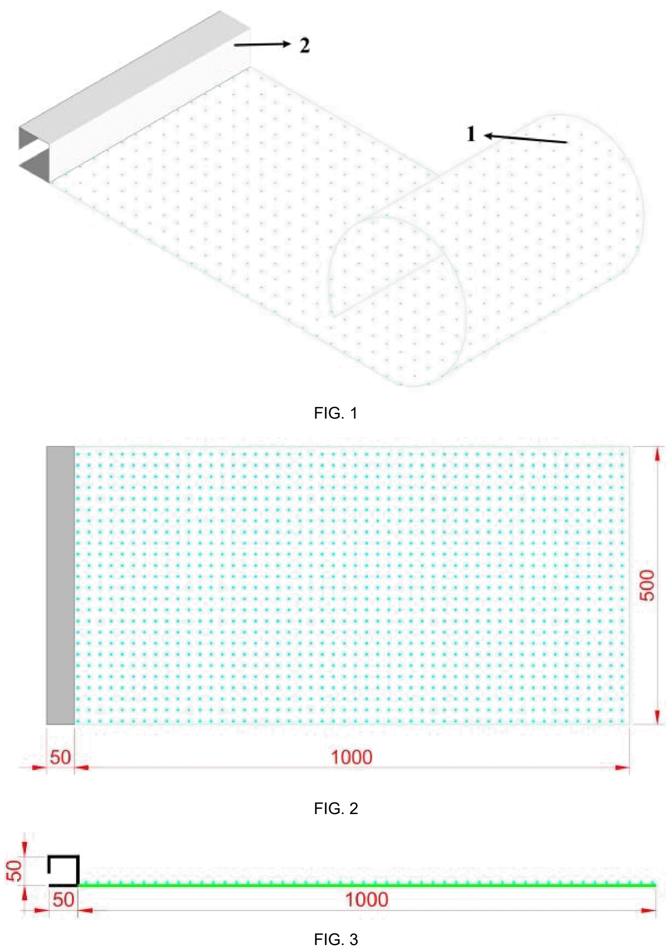

With respect to this embodiment, referring to FIGS. 1 to 3, the size of the rigid portion 2 in one dimension (for example, its length) is smaller than or equal to one edge (for example, the width) of the corresponding flexible portion 1, and,
the maximum size of the rigid portion 2 in other dimensions (for example, its width and height) is much smaller than another edge (for example, the length) of the flexible portion, so that the LED flexible membrane is able to wrap the rigid portion by curling the flexible portion.

In some embodiments,
the light transmittance of the LED flexible membrane screen is greater than or equal to 80%.

Typically, the light transmittance is no less than 80% and no more than 95%. This is advantageous as it ensures that the installation of the LED flexible membrane screen does not affect the lighting of the space behind it. Meanwhile, it helps to maintain uniform color reproduction and a grain-free image on the screen, making it particularly suitable for applications such as window displays or architectural glass curtain walls.

In some embodiments,
the LED flexible membrane screen is an individually controllable LED flexible membrane screen, and the thickness of the LED flexible membrane screen is 3-5 mm.

It can be understood that the individual control means that each LED bead can be programmed individually, and this is advantageous to achieve the pixel-level dynamic effect such as text scrolling, pattern gradation, particle animation, and the like. In other words, each LED bead is controlled by an independent signal to achieve the pixel-level dynamic effect.

In some embodiments,
the housing is in the shape of a square tube or a round tube.

In some embodiments,
circuits can be disposed within the housing.

Exemplarily, circuit modules with PCBs can also be disposed within the housing, including but not limited to a power supply module and a signal processing module that controls the LED beads in the LED luminous body, and the like.

In some embodiments,
a display surface of the LED flexible membrane screen is rectangular, and
the size of the housing in one dimension is equal to the length of one edge (e.g. the width dimension) of the rectangle.

For example, when the housing is in the shape of a square tube, the length of the square tube is equal to the width of the rectangle.

In some embodiments,
each LED display unit is free of a PCB,

The LED display unit is provided with at least a first flexible wire and a second flexible wire which are parallel, and a plurality of (multiple) LED luminous bodies arranged in sequence, along a direction from one side of the multi-layer structure where the rigid portion is located to the other side of the multi-layer structure,
wherein,
each LED luminous body includes an LED bead that is an individually controlled bead. The beam is controlled to operate by at least two pins. For example, the two pins are connected to the first flexible wire and the second flexible wire, respectively.

Exemplarily, when the LED bead is a two-wire individually-controlled bead, the LED display unit includes a first flexible wire and a second flexible wire. The first flexible wire and the second flexible wire are power supply wires and can also be used to transmit a signal to the bead in each LED luminous body to control its operating state. It should be noted that in this case, the first flexible wire and the second flexible wire serve as power supply wires and are capable of carrying carrier waves to transmit a control signal to each LED luminous and the LED bead therein.

Further, when the LED bead is a three-wire individually-controlled bead, the LED display unit further includes a third flexible wire. At this time, the first flexible wire and the second flexible wire are power supply wires, and the third flexible wire is a signal wire, which is used to transmit a signal to the bead in each LED luminous body to control its operating state.

Exemplarily, all of the LED display units are connected in parallel, enabling the LED flexible membrane screen to be cropped while still functioning normally as an LED flexible membrane screen integrated with its rigid portion after cropping. For instance, this parallel connection has the following characteristics: all of the LED luminous bodies within each LED display unit only receive DIN signals and do not transmit any DOUT signals externally. The third flexible wire, serving as a signal line, connects each LED luminous body in a bus mode. This facilitates the LED luminous bodies to continue receiving DIN signals and operating normally after cropping, thereby ensuring that the LED flexible membrane screen integrated with its rigid portion after cropping can function normally. It should be noted that, in addition to the aforementioned parallel connection, all of the LED luminous bodies within each LED display unit can also adhere to a resumable signal transmission mode. That is, the preceding LED luminous body within the LED display unit receives the DIN signal and then externally transmits the DOUT signal to the subsequent LED luminous body. In this scenario, the LED flexible membrane screen can still be cropped as needed after leaving the factory, and the LED flexible membrane screen, which remains integrated with its rigid portion after cropping, can continue to operate normally.

That is, in an alternative embodiment, the flexible portion is able to be cropped, and the cropping does not affect the display function of the remaining flexible portion as the flexible membrane screen.

Exemplarily, the wire diameters of all the wires do not significantly affect the visual effect of the LED display unit and the 360-degree illumination of the LED display unit.

Further, for the LED luminous body or the LED bead, all necessary circuit components are encapsulated inside the LED luminous body or the bead, and failure such as soldering short circuit or cold joints due to the PCB is avoided, thereby achieving a better structural design of the LED flexible membrane screen.

In some embodiments,
each LED partition can be individually controlled to emit light or not.

Typically, an inactive LED partition can be automatically powered down to reduce power consumption.

In some embodiments,
the materials of the first flexible membrane, the second flexible membrane, and the flexible interlayer include, but are not limited to, silicone, PVC, PET, or polyurethane polymer flexible materials.

In some embodiments,
the LED bead is a bead that emits light with a 360° beam angle.

Since the maximum outer diameter of the LED bead can achieve a very small size, the present disclosure can easily encapsulate the LED beads, the circuits between two layers of flexible membranes by means of the sandwich structure embodied by the multi-layer structure disclosed in the present disclosure, so that the total thickness of the LED flexible membrane screen can be controlled to be 3-5 mm. Thereby, he flexible property is maintained.

In addition, in some embodiments, the present disclosure also discloses a manufacturing method of the LED flexible membrane screen, including the following steps:
two first and second flexible wires parallel to each other are arranged; optionally, a third flexible wire may also be arranged;
a plurality of (multiple) LED luminous bodies are arranged in sequence along the direction of the first flexible wire, the second flexible wire, and optionally the third flexible wire;
each LED luminous body is electrically connected to the first flexible wire and each LED luminous body is electrically connected to the second flexible lead; optionally, the third flexible wire is electrically connected to each LED luminous body;
the above steps are repeated to achieve a plurality of (multiple) LED luminous bodies in an array, wherein the LED flexible membrane screen includes a plurality of (multiple) LED luminous bodies in an array, wherein at least a portion of the plurality of (multiple) LED luminous bodies in the array form a first LED display unit and a first LED partition thereof, and another portion of the plurality of (multiple) LED luminous bodies in the array form a second LED display unit and a second LED partition thereof;
all of the LED display units and the LED partitions thereof are wrapped using thermally conductive silicone; and
the first flexible membrane and the second flexible membrane are respectively wrapped on both sides of the flexible interlayer to realize a flexible portion of the LED flexible membrane screen.

In some embodiments,
the first flexible membrane, the second flexible membrane and the flexible interlayer form a multi-layer structure as a flexible portion of the LED flexible membrane screen,
the shapes of the first flexible membrane, the second flexible membrane, and the flexible interlayer are all the same, which is a first shape,
edges of the first flexible membrane, the second flexible membrane, and the flexible interlayer are flush, and all have the same size, which is a first size; and
each LED display unit includes an LED luminous body and a flexible circuit connected with the LED luminous body, and the thickest wire in the flexible circuit has a second size, the second size being much smaller than the first size.

In some embodiments, the method further includes the following step:
a rigid portion is arranged and a circuit in the rigid portion is electrically connected with the flexible circuit in the flexible portion.

Referring to FIGS. 1-3, in some embodiments, the present disclosure discloses an LED flexible membrane screen including a flexible portion 1 and a rigid portion 2, and the flexible portion 1 is curlable, and the rigid portion 2 is in a shape of a square tube. FIGS. 2 to 3 illustrate the size in mm. The size of the display surface of the LED flexible membrane screen is 1000 mm * 500 mm, the rigid portion in the shape of a square tube is a square tube, the length of the square tube is 500 mm, the end surface of the square tube is square, and the edge length of the square is 50 mm.

The above is only specific embodiments of the present disclosure, but the protection scope of the present disclosure is not limited thereto, and any variations or substitutions easily conceivable by those skilled in the art within the technical scope of the present disclosure should be covered by the protection scope of the present disclosure. Therefore, the protection scope of the present disclosure should be subject to the protection scope of the claims.

## Claims

1. An LED flexible membrane screen, wherein:
the LED flexible membrane screen comprises a first flexible membrane and a second flexible membrane, and,
a flexible interlayer sandwiched between the first flexible membrane and the second flexible membrane,
wherein,
the first flexible membrane, the second flexible membrane and the flexible interlayer form a multi-layer structure as a flexible portion of the LED flexible membrane screen,
the first flexible membrane, the second flexible membrane, and the flexible interlayer have a same shape, which is a first shape,
the first flexible membrane, the second flexible membrane, and the flexible interlayer have a same size, which is a first size;
multiple LED partitions are arranged in the flexible interlayer, and
each LED partition comprises multiple LED display units, each LED display unit comprises an LED luminous body and a flexible circuit connected with the LED luminous body, and the thickest wire in the flexible circuit has a second size, the second size being much smaller than the first size.

2. The LED flexible membrane screen according to claim 1, wherein:
when the first flexible membrane, the second flexible membrane, and the flexible interlayer are all rectangular, the first size comprises the length and/or the width of the flexible membrane; and
when the first flexible membrane, the second flexible membrane, and the flexible interlayer are all square, the first size comprises the edge length of the flexible membrane.

3. The LED flexible membrane screen according to any of the preceding claims, wherein:
the second size is the outer diameter of the thickest wire in the flexible circuit.

4. The LED flexible membrane screen according to any of the preceding claims, wherein:
the flexible interlayer comprises a first flexible layer and a second flexible layer,
the first flexible layer is adjacent to the first flexible membrane,
the second flexible layer is adjacent to the second flexible membrane, and
the multiple LED partitions and LED display units are arranged between the first flexible layer and the second flexible layer, such that the LED partitions and the LED display units are sandwiched by the first flexible membrane, the first flexible layer, the second flexible layer and the second flexible membrane.

5. The LED flexible membrane screen according to any of the preceding claims, wherein:
the second size is determined according to the resolution and/or pixel density of the LED flexible membrane screen.

6. The LED flexible membrane screen according to any of the preceding claims, wherein:
the spacing of adjacent LED beads is determined according to the resolution and/or pixel density of the LED flexible membrane screen.

7. The LED flexible membrane screen according to any of the preceding claims, wherein:
the flexible interlayer is a thermally conductive flexible interlayer.

8. The LED flexible membrane screen according to any of the preceding claims, wherein:
the LED flexible membrane is configured to display bidirectionally on the respective outer sides of the first flexible membrane and the second flexible membrane, for example via LED beads.

9. The LED flexible membrane screen according to any of the preceding claims, wherein:
the LED flexible membrane screen comprises a rigid portion at one side of the multi-layer structure, wherein the multi-layer structure is formed by the first flexible membrane, the second flexible membrane and the flexible interlayer of , and the rigid portion comprises a hollow housing;
optionally, the rigid portion is suitable for use in installing/fixing a power supply module and/or a circuit module.

10. The LED flexible membrane screen according to claim 9, wherein:
the flexible portion of the LED flexible membrane is able to be curled to wrap the rigid portion when the LED flexible membrane is not deployed;
for example, the size of the rigid portion in one dimension is smaller than or equal to that of a corresponding edge of the flexible portion, and, the maximum size of the rigid portion in other dimensions is much smaller than another edge of the flexible portion, so that the LED flexible membrane is able to wrap the rigid portion by curling the flexible portion.

11. The LED flexible membrane screen according to any of the preceding claims, wherein:
the light transmittance of the LED flexible membrane screen is greater than or equal to 80%.

12. The LED flexible membrane screen according to any of the preceding claims, wherein:
the LED flexible membrane screen isa pixelcontrollable LED flexible membrane screen, and the LED flexible membrane screen has a thickness of 3-5 mm.

13. The LED flexible membrane screen according to any of the preceding claims, wherein:
the LED flexible membrane screen comprises multiple LED luminous bodies in an array, wherein at least a part of multiple LED luminous bodies in the array form a first LED display unit and a first LED partition thereof, and another part of the multiple LED luminous bodies in the array form a second LED display unit and a second LED partition thereof.

14. The LED flexible membrane screen according to any of the preceding claims, wherein:
the LED bead is a bead that emits light with a 360° omni-directional beam angle.

15. The LED flexible membrane screen according to any of the preceding claims, wherein:
the flexible portion is able to be cropped, and the cropping does not affect the display function of the remaining flexible portion as the flexible membrane screen.
